Europäisches Patentamt

European Patent Office

Office européen des brevets

(11) Veröffentlichungsnummer: **0 436 833 A1**

# (12) EUROPÄISCHE PATENTANMELDUNG

(21) Anmeldenummer: 90123251.2

(22) Anmeldetag: 04.12.90

(51) Int. Cl.5: **H05K 13/04**

(30) Priorität: **12.01.90 DE 4000778**

(43) Veröffentlichungstag der Anmeldung:
**17.07.91 Patentblatt 91/29**

(84) Benannte Vertragsstaaten:
**CH DE FR GB IT LI SE**

(71) Anmelder: **Siemens Aktiengesellschaft Wittelsbacherplatz 2**

W-8000 München 2(DE)

(72) Erfinder: **Grasmüller, Horst**
**Kapellenstrasse 4**
**W-8083 Mammendorf(DE)**
Erfinder: **Hau, Winfried, Dipl.-Ing.**
**Hans-Mielich-Strasse 19**
**W-8000 München 90(DE)**

(54) Adapter für eine Saugpipette.

(57) Für Bestückautomaten, insbesondere in der SMD-Technik werden bisher meist aus einem Stück bestehende steife Adapter eingesetzt. Durch die in der Praxis vorkommenden Abweichungen vom idealen Zustand können durch derartige Adapter (2) Fehler bei der Aufnahme, beim Transport und beim Bestücken von Bauelementen resultieren. Da eine Saugpipette (1) mit einem Adapter (2) nicht zwangsläufig orthogonal auf einer Bestückoberfläche (6) steht und des weiteren Ungenauigkeiten in der Geometrie eines Bauelementes (4) vorhanden sein können, wird durch einen zweiteiligen Adapter, dessen beide Teile gegeneinander beweglich und arretierbar sind, für einen Ausgleich derartiger Abweichungen gesorgt.

FIG 2

EP 0 436 833 A1

## ADAPTER FÜR EINE SAUGPIPETTE

Die Erfindung betrifft einen Adapter für eine Saugpipette zur Anpassung an die Größe von aufzunehmenden elektronischen Bauelementen, insbesondere zum Einsatz an SMD-Bestückautomaten, wobei der Adapter am unteren Ende der Saugpipette angebracht ist und auf der dem Bauelement zugewandten Seite eine Saugfläche zur Aufnahme von Bauelementen aufweist.

Bei der SMD-Technik (surface mounted device) werden elektronische Bauelemente im Bestückautomat mittels Vakuumsaugpipetten aufgenommen und transportiert, sowie zur Bestückung der Leiterplatte abgesetzt. Zur Bestückung großer Bauelemente werden entsprechend große Adapter mit entsprechend großen Haltekräften benötigt. Hierzu sind bei gleichbleibender Größe der Saugpipetten sog. Bestück-Adapter im Einsatz. Dieses sind Adapter, die der Bestückkopf in der Regel automatisch wechseln kann und dadurch die an ihm angebrachten Saugpipetten auf unterschiedliche Körperflächen der verschiedenen elektronischen Bauelemente anpaßt. Im Idealfall ist vorgesehen, daß die Achse einer Saugpipette orthogonal auf der Oberfläche der zu bestückenden Leiterplatte (Bestückoberfläche) steht. Da bisher bekannte und eingesetzte Adapter eine steife und in ihrer Richtung nicht variable Verbindung zwischen Saugpipette und Adapter herstellen, ergeben sich bei der Handhabung größerer elektronischer Bauelemente verschiedene Probleme.

Falls bei der Aufnahme eines elektronischen Bauelementes durch eine Saugpipette mit einem aufgesetzten Adapter die Endfläche des Adapters, die als Saugfläche bezeichnet wird, nicht parallel zur Oberfläche des Bauelementes ausgerichtet ist, kommt es zu Fehlern in der Aufnahme. Durch den hierbei vorhandenen Winkel, den die Saugfläche des Adapters und die Oberfläche des Bauelementes gegenseitig bilden, wird Falschluft angesaugt, so daß das Bauelement gar nicht angesaugt oder unter Umständen schief aufgenommen wird.

Hat eine Saugpipette mit einem Adapter ein Bauelement aufgenommen, so ist als nächstes die Ausrichtung der Ebene der Anschlußbeinchen der Bauelemente in bezug auf die Oberfläche der Leiterplatte, die zu bestücken ist, wichtig. Sind diese beiden Ebenen, die Beinchenebene und die Bestückebene, nicht parallel, so kommt es beim Aufsetzen des Bauelementes zu unkontrollierten Bewegungen, beispielsweise zu Verdrehungen an der Bestückposition.

Eine Möglichkeit die Position eines Bauelementes, das an einer Saugpipette angesaugt ist, zu bestimmen, besteht darin, das Bauelement zwischen der Aufnahme und der Bestückung auf einer Meßebene aufzusetzen und auszumessen. Die Meßebene ist in diesem Fall parallel zur Leiterplatte (Bestückoberfläche), so daß die Situation bei der Bestückung simuliert werden kann. Ist jedoch das Bauelement in bezug zur Meßebene gekippt, so kann es zu Fehlmessungen kommen.

Der Erfindung liegt die Aufgabe zugrunde, einen Adapter für eine Saugpipette zur Verfügung zu stellen, bei dem die Ausrichtung der Saugfläche in bezug auf die Saugpipette und nach Maßgabe der geometrischen Gegebenheiten eines Bauelementes variabel einstellbar ist und in einer bestimmten Stellung arretiert werden kann.

Die Lösung dieser Aufgabe geschieht durch den kennzeichnenden Teil des Anspruches 1.

Der Erfindung liegt die Erkenntnis zugrunde, daß durch die Zweiteilung eines Adapters in ein fest an die Saugpipette anschließbares Teil, den Grundkörper, und in ein am Grundkörper befestigtes, aber in bezug auf diesen bewegliches Teil, das in einer bestimmten Stellung realtiv zum Grundkörper arretierbar ist, Fehler bei der Aufnahme, dem Transport, dem Vermessen und dem Absetzen von Bauelementen in Bestückautomaten behoben werden können. Die Ursache derartiger Fehler, nämlich die nicht parallele Ausrichtung von Saugfläche des Adapters, Bauelementoberfläche, Ebene der Anschlußbeinchen, sowie einer eventuell vorhandenen Meßebene verbunden mit einer nicht orthogonal zu diesen Ebenen ausgerichteten Achse der Saugpipette können durch die Möglichkeit der variablen Ausrichtung der Saugfläche ausgeglichen werden. Sobald die Saugpipette mit dem Adapter das Bauelement berührt, kann sich der in diesem Moment bewegliche Körper des Adapters gegenüber dem Grundkörper derart verstellen, daß die Saugfläche exakt auf dem Bauelement aufsetzt. Mit in dieser Stellung arretiertem Adapter wird das Bauelement zuverlässig aufgenommen.

Um das Vakuum der Saugpipette über den Adapter bis zur Saugfläche zu erhalten, müssen die beiden gegeneinander beweglichen Teile des Adapters in der arretierten Stellung derart aneinander anliegen, daß sie zumindest annähernd gasdicht abschließen. Dies hat den Vorteil, daß zur Arretierung gleichzeitig das Vakuum der Saugpipette herangezogen werden kann.

Eine besondere Ausgestaltung der Erfindung sieht vor, daß unter der Wirkung der vom Vakuum erzeugten Kraft, die sich als Andruckkraft bezüglich des beweglichen Körpers auf den Grundkörper darstellt, ein Reibschluß zwischen diesen beiden Körpern zur gegenseitigen Arretierung erzeugt wird.

Zur Erzeugung eines Reibschlusses ist es nicht nötig, einen großflächigen Kontakt zwischen beiden Teilen des Adapters herzustellen. Es ist sogar vorteilhaft, lediglich einen umlaufenden Ring als Kontaktfläche vorzusehen, der jedoch eine vollständige Abdichtung erzeugt.

Für den Fall, daß die Saugpipette oder der Bestückkopf mit mechanischen Zangen ausgerüstet ist, wäre es vorteilhaft, diese für eine mechanische Klemmung des beweglichen Körpers zur Arretierung einzusetzen. Die mechanische Klemmung kann jedoch auch durch separate Bauteile erfolgen.

Eine besonders vorteilhafte Ausgestaltung sieht vor, daß der Grundkörper und der bewegliche Körper in Form eines Kugelgelenkes miteinander verbunden sind. Dies hat den Vorteil, daß eine Verstellung entsprechend eines Kippwinkels in jeder Richtung gleichmäßig durchführbar ist, da die gesamte Konstruktion annähernd radialsymmetrisch aufgebaut ist.

Um Behinderungen bei der Aufnahme eines Bauelementes durch einen zu großen Kippwinkel zu vermeiden, ist es vorteilhaft, die Saugfläche durch den Einsatz eines zwischengeschalteten Saugstutzens in ausreichendem Abstand zum Zentrum des Kugelgelenkes zu plazieren.

Eine weitere vorteilhafte Ausgestaltung sieht den Einsatz einer plastisch verformbaren Masse vor, die zwischen Grundkörper und beweglichem Körper plaziert ist. Diese Masse sollte bei der Verstellung des beweglichen Körpers so wenig Rückstellkräfte wie möglich erzeugen. Durch die Auslegung der Masse in der Form, daß sie im wesentlichen plastisch verformbar ist, wird dafür gesorgt, daß auf die arretierten Teile praktisch keine Kräfte wirken, die von der Masse während der Verstellung zwischen Grundkörper und beweglichem Körper erzeugt wurden.

Der Einsatz einer plastisch verformbaren Masse, deren Zähigkeit von außen beeinflußbar ist, bietet hier wesentliche Vorteile, da die Anteile bezüglich plastischer oder elastischer Verformbarkeit der Masse gezielt steuerbar sind.

Im folgenden wird anhand von schematischen Figuren ein Ausführungsbeispiel beschrieben.

Figur 1    zeigt einen steifen Adapter entsprechend dem Stand der Technik.

Figur 2    zeigt einen Adapter, bestehend aus einem Grundkörper 7 und einem beweglichen Körper 9 in Form eines Kugelgelenkes unter Zwischenschaltung einer plastisch verformbaren Masse 8.

Figur 3    zeigt einen Adapter entsprechend der Figur 2, wobei der Kontakt zwischen Grundkörper 7 und Körper 9 großflächig ausgebildet ist.

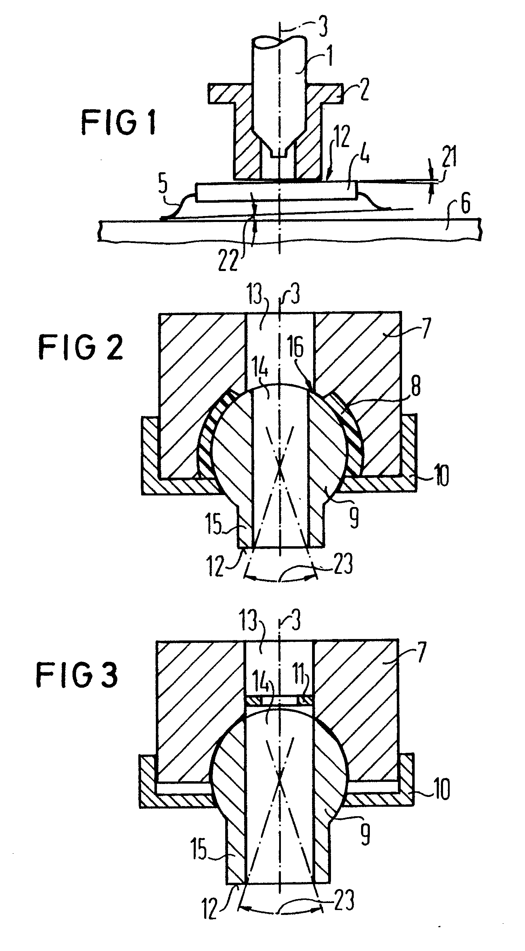

In der Figur 1 ist eine Saugpipette 1 mit einem an ihrem unteren Ende angebrachten steifen Adapter 2 mit entsprechender Saugfläche 12 dargestellt. Die Aufnahme von Bauelementen 4 mit Anschlußbeinchen 5, das Transportieren und das Absetzen auf der Bestückoberfläche 6, beispielsweise einer Leiterplatte, geschieht bei idealen Vorausetzungen problemlos. Da jedoch sehr häufig die Achse 3 der Saugpipette 1 nicht orthogonal auf der Saugfläche 12 steht, entsteht ein Winkel 21 zwischen den beiden genannten Flächen. Weiterhin bilden die unteren Enden der Anschlußbeinchen 5 des Bauelementes 4 eine Ebene, die in idealer Weise parallel zur Bestückoberfläche 6 ausgerichtet sein sollte. Bei in der Praxis vorkommenden Ungenauigkeiten entsteht hier der Winkel 22, der, ausgehend von der Achse 3 der Saugpipette 1, zum Winkel 21 addiert wird. Die Form des Adapters 2 und die Ausrichtung des Bestückkopfes, an dem die Saugpipette 1 angebracht ist, sind somit Ursachen für die fehlerhafte Ausrichtung entsprechend dem Winkel 21. Der Winkel 22 ist abhängig von der ungleichmäßigen Form eines Bauelementes.

Die Figur 2 zeigt einen Adapter, der aus einem Grundkörper 7 und einem Körper 9 besteht, wobei hier die Verbindung in Form eines Kugelgelenkes ausgeführt ist. Der Grundkörper 7 wird über einen Klemmsitz an der Saugpipette 1 befestigt und enthält die Bohrung 13, über die das Vakuum zur Bohrung 14 und entsprechend zur Saugfläche 12 weitergeleitet wird. Zwischen dem kugelförmig ausgebildeten Körper 9 und der Saugfläche 12 ist ein Saugstutzen 15 zwischengeschaltet, damit sich der Körper 9 an ein an der Saugfläche 12 angesetztes Bauelement 4 mit der Saugfläche 12 anlegen kann. Der Körper 9 ist in diesem Fall mittels einer Halterung 10 beweglich mit dem Grundkörper 7 verbunden. Die Halterung 10 kann in bekannter Art und Weise am Grundkörper 7 angebracht werden. Wesentlich ist die frei Bewegbarkeit des Körpers 9 bezüglich des Grundkörpers 7 solange kein Bauelement einer Saugfläche 12 gehalten wird bzw. solange kein Vakuum anliegt. Für den Fall, daß über die Bohrung 13 bei gleichzeitig anliegendem Bauelement 4 durch die Saugpipette evakuiert wird, wird durch den äußeren Atmosphärendruck eine Andruckkraft auf den Körper 9 erzeugt, die diesen an den Grundkörper 7 andrückt. Als Kontaktfläche ist hierbei in der Regel nur ein umlaufender Ring 16 nötig, der für den praktischen Einsatz ausreichend gasdicht sein muß. Die hier dargestellte Version beinhaltet einen Ring 16 zugleich mit einer zwischengeschalteten plastisch verformbaren Masse 8. Diese beiden Versionen sind jedoch jede für sich einzeln einsetzbar. Der Zweck der plastisch verformbaren Masse 8 besteht ebenfalls in der freien Beweglichkeit des Körpers 9, solange keine Andruckkraft erzeugt wird. Wird die Stellung des beweglichen Körpers 9 entsprechend dem Kippwinkel 23 an ein aufzunehmendes Bauelement 4 angepaßt, so werden keinerlei Kräfte, die durch elastisches Verformen einer zähen Masse auftreten könnten, erzeugt. Beim Aufsetzen des Adapters auf das Bauelement wird der Körper 9 entweder an einen Ring 16 oder an eine plastisch verformbare Masse angedrückt und durch die in diesem Moment erzeugte Andrückkraft durch das Vakuum arretiert. Der Körper 9 drückt sich dabei in die plastisch verformbare Masse ein, wobei in diesem Fall genauso wie im Kontakt zu einem Ring 16 ein Reibschluß entsteht. Für den Fall, daß die Zähigkeit der plastisch verformbaren Masse 8 von außen beeinflußbar ist, ergeben sich besondere Vorteile bezüglich der gezielten Steuerung der plastischen Anteile der Masse 8 im Verhältnis zu den elastischen.

Die Arretierung des beweglichen Körpers 9 bezüglich des Grundkörpers 7 ist ebenso mittels Spannzangen oder mittels einer Magnetkupplung möglich. Die Spannzangen würden die Arretierung direkt bewirken, wobei die Magnetkupplung ebenfalls mittels eines Reibschlusses zwischen Körper 9 und Grundkörper 7 funktionieren würde.

Die Arretierung des Adapters erfolgt in der Regel beim ersten Aufsetzen auf ein Bauelement. Falls nötig, kann durch kurzzeitigesUnterbrechen des Vakuums, beispielsweise beim Aufsetzen des Bauelementes auf einer Meßstation, eine Nachstellung des beweglichen Körpers 9 erfolgen. In Anschluß daran würde jedoch durch Anlegen des Vakuums eine Arretierung sofort wieder hergestellt.

Die Figur 3 zeigt einen Adapter entsprechend der Figur 2, der jedoch eine große Kontaktfläche zwischen beweglichem Körper 9 und Grundkörper 7 beinhaltet. Es liegt hier ebenfalls ein Kugelgelenk vor, wobei jedoch die gesamte Kontaktfläche zwischen den beiden wesentlichen Teilen des Adapters großflächig ist und für den Fall, daß durch das Vakuum eine Andruckkraft erzeugt wird, ein ausreichender Reibschluß erfolgt. Es ist ebenfalls denkbar, daß der Kontakt zwischen Körper 9 und Grundkörper 7 lediglich über einen Ring 16 geschieht. Die eingezeichneten Strömungswiderstände 11 sind nötig, wenn die Durchgangsbohrung 14 relativ klein ist und für sich genommen einen Strömungswiderstand darstellen würde. Dies wäre insofern nachteilig, als der an sich bewegliche Körper 9 durch den vorhandenen Strömungswiderstand der Bohrung 14 bereits angesaugt werden würde. Da ein Erzeugen des Vakuums, verbunden mit einer Ansaugung, jedoch erst beim Aufsetzen des Adapters auf das Bauelement 4 geschehen soll, ist dafür zu sorgen, daß vorher keinerlei Reibschluß und entsprechend keinerlei Andruckkräfte zwischen Körper 9 und Grundkörper 7 entstehen.

**Patentansprüche**

1. Adapter (2) für eine Saugpipette (1) zur Anpassung an die Größe von aufzunehmenden elektronischen Bauelementen (4), insbesondere zum Einsatz an SMD-Bestückautomaten, wobei der Adapter (2) am unteren Ende der Saugpipette (1) angebracht ist und auf der dem Bauelement (4) zugewandten Seite eine Saugfläche (12) zur Aufnahme von Bauelementen (4) aufweist,
   **gekennzeichnet durch**

   - einen fest an die Saugpipette (1) anschließbaren Grundkörper (7) und
   - einen in Richtung des Bauelementes (4) mit dem Grundkörper (7) verbundenen und in bezug auf diesen beweglichen Körper (9) mit der Saugfläche (12), wobei der Körper (9) relativ zum Grundkörper (7) in jeder einem Kippwinkel (23) entsprechenden Stellung arretierbar ist.

2. Adapter (2) nach Anspruch 1,
   **dadurch gekennzeichnet,**
   daß ein von der Saugpipette (1) erzeugtes Vakuum mittels einer Bohrung (13) im Grundkörper (7) und mittels einer Bohrung (14) im Körper (9) an der Saugfläche (12) anliegt.

3. Adapter (2) nach Anspruch 2,
   **dadurch gekennzeichnet,**
   daß der Körper (9) mit an der Saugfläche (12) angesaugtem Bauelement (4) und unter Wirkung einer vom Vakuum erzeugten Kraft mittels Reibschluß am Grundkörper (7) arretierbar ist.

4. Adapter (2) nach Anspruch 3,
   **dadurch gekennzeichnet,**
   daß als Kontaktfläche im arretierten Zustand zwischen Grundkörper (7) und Körper (9) zumindest ein umlaufender Ring (16) vorhanden ist.

5. Adapter (2) nach Anspruch 1,
   **dadurch gekennzeichnet,** daß der Körper (9) mittels einer mechanischen Klemmung am Grundkörper (7) arretierbar ist.

6. Adapter (2) nach einem der vorhergehenden Ansprüche,
   **dadurch gekennzeichnet,**
   daß der Grundkörper (7) und der bewegliche Körper (9) in Form eines Kugelgelenkes miteinander verbunden sind.

7. Adapter (2) nach Anspruch 6,
   **dadurch gekennzeichnet,**
   daß am kugelförmig ausgebildeten Körper (9) in Verlängerung zur Bohrung (14) ein Saugstutzen (15) vorhanden ist, wobei die Stirnfläche des Saugstutzens (15) die Saugfläche (12) bildet.

8. Adapter (2) nach einem der Ansprüche 1 bis 4, 6 oder 7,
**dadurch gekennzeichnet,**
daß zwischen Grundkörper (7) und beweglichem Körper (9) eine Schicht einer plastisch verformbaren Masse (8) plaziert ist.

9. Adapter (2) nach Anspruch 8,
**dadurch gekennzeichnet,**
daß die Zähigkeit der plastisch verformbaren Masse von außen beeinflußbar ist.

FIG 1

FIG 2

FIG 3

Europäisches
Patentamt

**EUROPÄISCHER
RECHERCHENBERICHT**

Nummer der Anmeldung

**EP 90 12 3251**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | IBM TECHNICAL DISCLOSURE BULLETIN. vol. 25, no. 7A, Dezember 1982, NEW YORK US Seiten 3423 - 3425; T.L. LEUNG: "Insertion Head For Multi-size Square modules" * das ganze Dokument * <br> – – – | 1 | H 05 K 13/04 |
| A | IBM TECHNICAL DISCLOSURE BULLETIN. vol. 25, no. 9, Februar 1983, NEW YORK US Seiten 4643 - 4644; G.R. ARENT: "Individual Chip Rework Probe" * Seite 4644, Absatz 2; Figur 1 * <br> – – – | 1,2,6,7 | |
| A | RESEARCH DISCLOSURE. no. 269, September 1986, HAVANT GB Seite 516 "Robotic Vacuum Tip with Compliancy but not Resiliency." * Seite 516, Absatz 2; Figur 1 * <br> – – – – – | 1,2,6 | |

| RECHERCHIERTE SACHGEBIETE (Int. Cl.5) |
|---|
| H 05 K <br> H 01 L <br> B 25 B |

Der vorliegende Recherchenbericht wurde für alle Patentansprüche erstellt

| Recherchenort | Abschlußdatum der Recherche | Prüfer |
|---|---|---|
| Den Haag | 09 April 91 | RIEUTORT A.S. |